# Europäisches Patentamt

# European Patent Office

# Office européen des brevets

(19)

(11) Veröffentlichungsnummer: **0 044 493**
**B1**

(12) **EUROPÄISCHE PATENTSCHRIFT**

(45) Veröffentlichungstag der Patentschrift:
14.11.84

(21) Anmeldenummer: 81105412.1

(22) Anmeldetag: 11.07.81

(51) Int. Cl.³: **H 03 L 7/18, H 04 N 5/04**

(54) Frequenz/Phasenregelschleife und deren Verwendung als Fernseh- bzw. Farbfernsehgerät-Teilschaltung.

(30) Priorität: **23.07.80 DE 3027828**

(43) Veröffentlichungstag der Anmeldung:
**27.01.82 Patentblatt 82/4**

(45) Bekanntmachung des Hinweises auf die Patenterteilung:
**14.11.84 Patentblatt 84/46**

(84) Benannte Vertragsstaaten:
**DE FR GB IT NL**

(56) Entgegenhaltungen:
**DE - A - 2 312 266**
**DE - A - 2 943 912**
**GB - A - 2 030 804**
**US - A - 3 591 716**
**PRAKTIKER, Heft 20/1979; Bilderzeitung GmbH, Wien,**
**"Kanalquarz" durch Prom abgelöst, Seiten 33, 35**
**BAUTEILE REPORT, 15. Jahrgang (1977), Heft 3,**
**Siemens Aktiengesellschaft, Berlin und München**
**HEINRICH KESZLER "S187 - ein universell**
**anwendbarer PLL-Baustein zur Frequenzsynthese"**
**Seiten 87-90**

(73) Patentinhaber: **Deutsche ITT Industries GmbH,**
**Hans-Bunte-Strasse 19 Postfach 840, D-7800 Freiburg**
**(DE)**

(84) Benannte Vertragsstaaten: **DE**

(73) Patentinhaber: **ITT INDUSTRIES INC., 320 Park Avenue,**
**New York, NY 10022 (US)**

(84) Benannte Vertragsstaaten: **FR GB IT NL**

(72) Erfinder: **Elmis, Herbert, Ing.-grad., Berliner Strasse 86,**
**D-7809 Denzlingen (DE)**
Erfinder: **Novotny, Bernd, Ing.-grad., Belchenstrasse 12,**
**D-7803 Gundelfingen (DE)**

(74) Vertreter: **Stutzer, Gerhard, Dr., Deutsche ITT Industries**
**GmbH Patent- und Lizenzabteilung**
**Hans-Bunte-Strasse 19 Postfach 840, D-7800 Freiburg**
**(DE)**

## Beschreibung

Die Erfindung betrifft Frequenz/Phasenregelschleifen mit einem die Frequenzkonstanz bestimmenden Referenzoszillator, mit einem frequenzsteuerbaren Generator von demgegenüber geringerer Frequenzkonstanz, jedoch um eine bis drei Grössenordnungen höherer Frequenz, mit einem dem Generator nachgeschalteten Frequenzteiler, von dem ein mit der Referenzfrequenz gleichfrequentes Ausgangssignal zusammen mit dem Referenzsignal einer digitalen Phasenvergleichsstufe zugeführt ist, deren Ausgangssignal die Generatorfrequenz über eine als Tiefpassfilter arbeitende digitale Integrierstufe steuert, vgl. den Oberbegriff des Anspruchs 1 und die Zeitschrift «Bauteile Report», 1977, Seiten 87 bis 90.

Derartige Regelschleifen werden auch als phasenverriegelte Schleifen (im Englischen 'phase-locked loops') bezeichnet und sind in der Literatur ausführlich beschrieben, vgl. z.B. das Buch von B. Best «Theorie und Anwendungen des Phase-Locked Loops», Aarau/Schweiz, 1976. Bei den bisher bekannten Frequenz/Phasenregelschleifen ist der frequenzsteuerbare Generator (vgl. den Oberbegriff des Anspruchs 1) ein mittels einer Gleichspannung spannungsgesteuerter Oszillator (im Englischen 'voltage-controlled oscillator', abgekürzt 'VCO'), während die Phasenvergleichsstufe entweder eine analog-lineare Charakteristik aufweisen kann oder nach digitalen Prinzipien arbeitet. Wie die Durchsicht der umfangreichen Patentliteratur und auch der sonstigen Literatur zeigt, ist in den bekannten Frequenz/Phasenregelschleifen der frequenzsteuerbare Generator immer ein analog spannungsgesteuerter. Demgegenüber schlägt die Erfindung einen neuen Weg zur Schaffung einer Frequenz/Phasenregelschleife ein und steuert entsprechend den Merkmalen des Anspruchs 1 die Frequenz des Generators nach digitalen Prinzipien durch Umschalten zwischen zwei Frequenzen, die sich um maximal etwa 10% voneinander unterscheiden.

Nach einer Weiterbildung der Erfindung kann der umschaltbare Generator mittels einer Zusatzphasenregelschleife mit analog spannungsgesteuertem Oszillator realisiert werden, deren Hochfrequenz-Generator auf einer einzigen Frequenz schwingt und die einen zwischen zwei der beiden Frequenzen des frequenzsteuerbaren Generators zugeordneten Teilungszahlen umschaltbaren Frequenzteiler enthält. Bei Ausbildung des Hochfrequenz-Generators als synchronisierter Quarzoszillator lässt sich die Frequenz/Phasenregelschleife nach der Erfindung in Farbfernsehgeräten als Teilschaltung zur Erzeugung des synchronisierten Horizontalablenksignals verwenden, wobei der Referenzoszillator durch die Horizontalsynchronimpuls-Abtrennstufe gebildet wird.

Die Erfindung wird nun anhand der Figuren der Zeichnung näher erläutert.

Fig. 1 zeigt schematisch das Blockschaltbild der Frequenz/Phasenregelschleife nach der Erfindung,

Fig. 2 zeigt ein Ausführungsbeispiel der Anordnung nach Fig. 1 mit den zur Realisierung der digitalen Phasenvergleichsstufe und der digitalen Integrierstufe erforderlichen Schaltmitteln,

Fig. 3 zeigt verschiedene Impulsdiagramme, wie sie beim Betrieb der Anordnung nach Fig. 2 auftreten,

Fig. 4 zeigt die erwähnte Weiterbildung,

Fig. 5 zeigt die Weiterbildung der Fig. 4 mit dem erwähnten Quarzoszillator, und

Fig. 6 zeigt die Ausbildung bei Verwendung der Erfindung in einem Farbfernsehgerät.

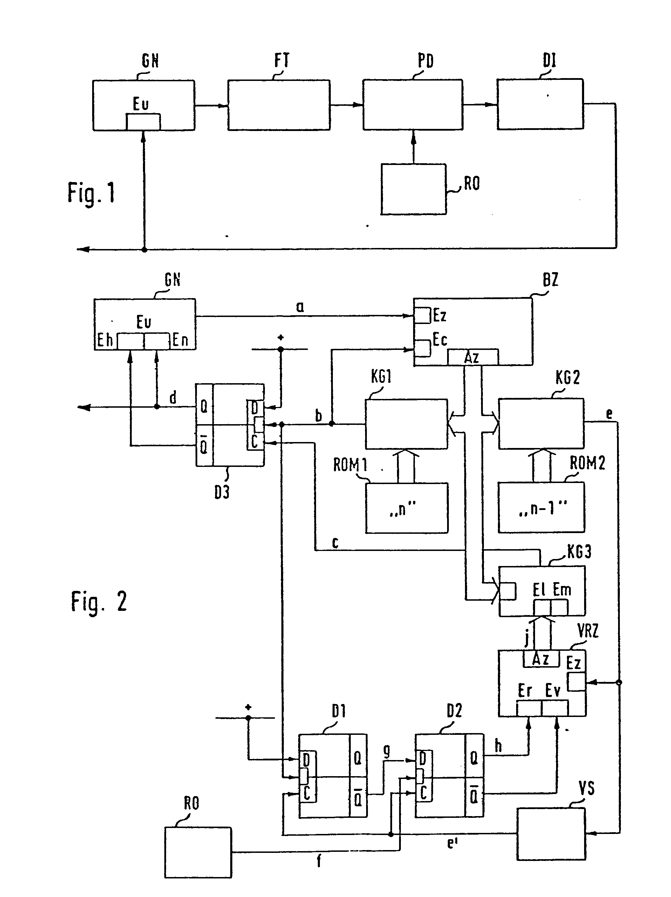

Im Blockschaltbild der Fig. 1 ist der frequenzsteuerbare Generator GN über seinen Umschalteingang Eu zwischen den beiden Frequenzen $f_1$, $f_2$ umschaltbar, wobei die zweite Frequenz $f_2$ um etwa 1 bis 10% grösser als die erste Frequenz $f_1$ ist. Der Generator GN kann dabei ein mit üblichen Mitteln realisierter LC-, RC- oder RL-Oszillator sein, wobei eines der frequenzbestimmenden Mittel über den Umschalteingang Eu zwischen zwei die beiden Frequenzen $f_1$, $f_2$ bestimmenden Werten umgeschaltet wird.

Der Ausgang des Generators GN ist mit dem Eingang des Frequenzteilers FT verbunden, der die Frequenz des Generator-Ausgangsignals auf die Frequenz des Ausgangssignals des Referenzoszillators RO herunterteilt, so dass die Phasenvergleichsstufe PD aus diesen beiden ihr zugeführten Signalen in üblicher Weise ein Regelsignal bilden kann. Im Falle der Verwendung der Frequenz/Phasenregelschleife in Frequenzsynthesesystemen ist der Frequenzteiler FT ein einstellbarer, so dass damit die Frequenz des Umschaltsignals einstellbar wird.

Das Ausgangssignal der Phasenvergleichsstufe PD wird in der digitalen Integrierstufe DI zeitlich gemittelt und zum erwähnten, dem Umschalteingang Eu des Generators GN zugeführten Umschaltsignal verarbeitet.

Durch die Umschaltbarkeit des Generators GN zwischen den beiden sich um maximal etwa 10% voneinander unterscheidenden Frequenzen ergibt sich der wesentliche Vorteil, dass das Auflösungsvermögen, also die minimale Schrittbreite der Frequenz/Phasenregelung, der Differenz der beiden Frequenzen entspricht. Da diese Differenz minimal etwa 1% der höheren der beiden Frequenzen beträgt, ist die Schrittbreite um etwa maximal den Faktor 100 besser als die Periodendauer dieser Frequenz.

Das Blockschaltbild der Fig. 2 zeigt ein Ausführungsbeispiel für die prinzipielle Anordnung nach Fig. 1. Dabei ist der Generator GN wiederum mit dem Umschalteingang Eu ausgestattet, der nun als Bedingungseingang Eh für die höhere Frequenz $f_2$ und als Bedingungseingang En für die niedrigere Frequenz $f_1$ realisiert ist. Der Frequenzteiler FT nach Fig. 1 ist in Fig. 2 als mindestens n-stufiger Binärzähler BZ realisiert, dessen Zähleingang Ez das Ausgangssignal a des Generators GN zugeführt ist; der Binärzähler BZ kann also im Bedarfsfall auch n + 1 Stufen haben.

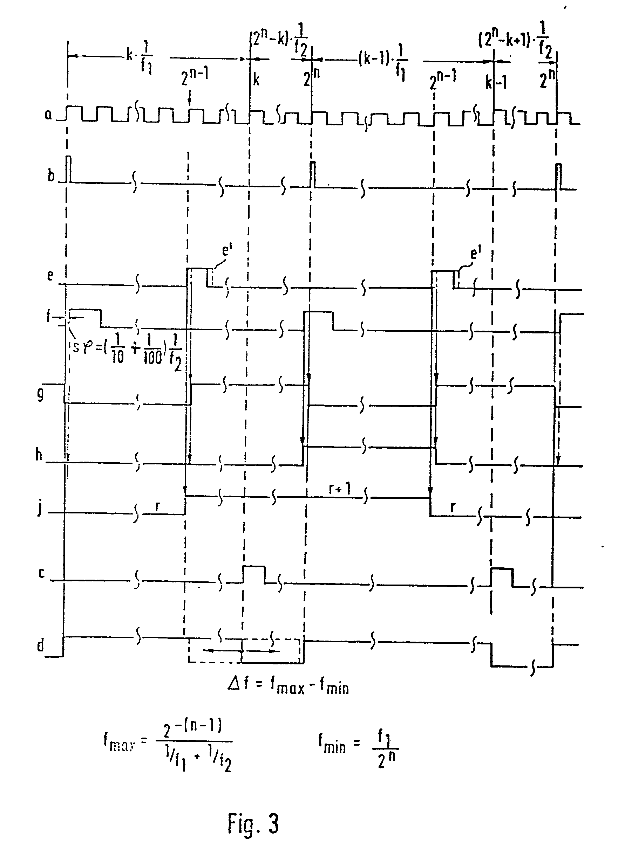

Das Ausgangssignal a des Generators GN ist in Fig. 3a schematisch gezeigt, wobei die während zwei Zählerumläufen des Binärzählers BZ auftretenden Impulse für wichtige Zeitphasen dieser zwei Umläufe gezeigt sind. Der Binärzähler BZ zählt auf $2^n$, wobei im ersten Zählerumlauf k Impulse der niedrigeren Frequenz $f_1$ und $2^n$-k Impulse der höheren Frequenz $f_2$ gezählt werden. Dagegen werden beim zweiten Zählerumlauf k-1 Impulse der niederen Frequenz $f_1$ und $2^n$n-(k+1) Impulse der höheren Frequenz $f_2$ gezählt. Die Zählerumlaufdauer des Binärzählers BZ ist also beim ersten Umlauf um die erwähnte Frequenzdifferenz grösser als beim zweiten Zählerumlauf.

Die Ausgänge der Binärzählerstufen sind parallel jeweils mit den ersten Eingängen des ersten, des zweiten und des dritten Koinzidenzgatters KG1, KG2, KG3 verbunden, was in Fig. 2 durch die bandförmigen Zuleitungen angedeutet ist. Die n zweiten Eingänge des ersten Koinzidenzgatters KG1 sind mit den Ausgängen des ersten Festwertspeichers ROM1 verbunden, in dem sich die Zahl $2^n$ als Speicherinhalt befindet. Das erste Koinzidenzgatter KG1 gibt also immer dann einen Ausgangsimpuls ab, wenn der Binärzähler BZ den Zählerstand $2^n$ erreicht bzw. durchläuft. Dieser Ausgangsimpuls ist seinem Rücksetzeingang Ec zugeführt und in Fig. 3b gezeigt. Diese Massnahme ist insbesondere dann wichtig, wenn die Stufenzahl des Binärzählers grösser als n gewählt wird.

Die n zweiten Eingänge des zweiten Koinzidenzgatters KG2 liegen an den Ausgängen des zweiten Festwertspeichers ROM2, in dem sich die Zahl $2^{n-1}$ befindet, so dass am Ausgang des zweiten Koinzidenzgatters KG2 immer dann ein Ausgangsimpuls auftritt, wenn der Binärzähler BZ den Zählerstand $2^{n-1}$ erreicht bzw. durchläuft. Dieses Ausgangssignal ist in Figur 3e gezeigt und dem Zähleingang Ez des (n-1)-stufigen Vorwärts/Rückwärts-Binärzählers VRZ zugeführt. Seine Stufenausgänge liegen parallel an den n-1 niederwertigen Eingängen E1 der n anderen Eingänge des dritten Koinzidenzgatters KG3, dessen höchstwertiger Eingang Em dauernd auf die binäre Eins gesetzt ist.

Das Ausgangssignal e des zweiten Koinzidenzgatters KG2 ist ferner über die Verzögerungsstufe VS, die beispielsweise aus zwei in Serie geschalteten Inverterstufen bestehen kann, dem jeweiligen Rücksetzeingang C des ersten und des zweiten D-Flipflops D1, D2 als Signal e' zugeführt. Der Taktsignaleingang des ersten D-Flipflops D1 ist mit dem Ausgang des ersten Koinzidenzgatters KG1 verbunden, während der D-Eingang dauernd auf konstantem Potential + liegt. Bei jedem Ausgangsimpuls b des ersten Koinzidenzgatters KG1 wird somit eine binäre Eins in das erste D-Flipflop D1 übernommen, die dort so lang verbleibt, bis das verzögerte Signal e' über den Rücksetzeingang C diese Eins wieder löscht. Am $\overline{Q}$-Ausgang des ersten D-Flipflops D1 tritt das zu dem eben geschilderten Flipflopverhalten inverse Signal g auf, wie es in Fig. 3g gezeigt ist. Dieses Ausgangssignal ist dem D-Eingang des zweiten D-Flipflops D2 zugeführt, während dessen Taktsignaleingang mit dem Ausgang des Referenzoszillators verbunden ist, vgl. das in Fig. 3f gezeigte Referenzsignal f. Bei jedem Impuls des verzögerten Signals e' übernimmt das zweite D-Flipflop D2 entweder eine binäre Eins oder eine binäre Null vom $\overline{Q}$-Ausgang des D-Flipflops D1. Welcher Binärwert übernommen wird, hängt von der Phasenlage zwischen dem Ausgangssignal b des ersten Koinzidenzgatters KG1 und dem Referenzsignal f ab. In Fig. 3 sind die beiden Möglichkeiten während der beiden gezeigten Zählerumläufe des Binärzählers BZ in den Fig. 3f und 3g gezeigt. Beim ersten Zählerumlauf tritt das Ausgangssignal b zeitlich vor dem Impuls des Referenzsignals f auf, d.h., während des vorausgegangenen Zählerumlaufs war die Umlaufdauer kürzer als die Periodendauer der Referenzimpulse. Mit der Vorderflanke des Signals b wird die binäre Eins in das D-Flipflop D1 übernommen, vgl. Fig. 3g, in der zu diesem Zeitpunkt am $\overline{Q}$-Ausgang somit der bei der vorausgesetzten positiven Logik den binären Nullzustand charakterisierende niedere Signalpegel auftritt.

Bei Eintreffen des verzögerten Signals e' wird das erste D-Flipflop D1 zurückgesetzt, so dass an dessen $\overline{Q}$-Ausgang die binäre Eins auftritt. Diese wird beim nächsten Impuls des Referenzsignals f vom D-Flipflop D2 übernommen.

Die dadurch am Q-Ausgang des zweiten D-Flipflops auftretende binäre Eins (vgl. Fig. 3h) wird, da der Q-Ausgang mit dem Bedingungseingang für Rückwärtszählen Er des Vorwärts/Rückwärts-Binärzählers VRZ verbunden ist, diesen auf Rückwärtszählen schalten, und somit wird der nächste auftretende Ausgangsimpuls e des zweiten Koinzidenzgatters KG2 in Rückwärtsrichtung gezählt. In gleicher Weise bewirkt die binäre Eins am $\overline{Q}$-Ausgang des zweiten D-Flipflops D2 über den Bedingungseingang Ev für Vorwärtszählen, dass der Vorwärts/Rückwärts-Binärzähler VRZ den dann nachfolgenden Ausgangsimpuls e des zweiten Koinzidenzgatters KG2 in Vorwärtsrichtung zählt.

Die beiden D-Flipflops D1, D2 stellen somit in Verbindung mit dem Vorwärts/Rückwärts-Binärzähler VRZ eine Phasenverschiebung zwischen der Dauer eines Binärzählerumlaufs und der Periode der Referenzimpulse fest und bewirken zusammen mit dem dritten Koinzidenzgatter KG3 und dem dritten D-Flipflop D3, dass der Generator GN zwischen den beiden Frequenzen $f_1$, $f_2$ so umgeschaltet wird, dass diese Phasendifferenz praktisch zu null wird. Hierzu liegen die Ausgänge Az der Stufen des Vorwärts/Rückwärts Binärzählers VRZ parallel an den n-1 niederwertigen Eingängen El der n anderen Eingänge des dritten Koinzidenzgatters KG3, dessen höchstwertiger Eingang Em dauernd auf die binäre Eins gesetzt ist und dessen Ausgangssignal c dem Rücksetzeingang C des dritten D-Flipflops D3 zugeführt ist, vgl. Fig. 3c. Für den vom Koinzidenzgatter KG3 überwachten Zählerstand r des Vorwärts/Rückwärts-Binärzählers VRZ gilt mit den im Kopf der Fig. 3 gewählten Definitionen die Beziehung r = k-1-$2^{n-1}$.

Das vom Ausgangssignal b des ersten Koinzidenzgatters KG1 veranlasste übernehmen der binären Eins in das dritte D-Flipflop D3 wird durch das Ausgangssignal c des dritten Koinzidenzgatters KG3 bei Erreichen des Zählerstandes r des Vorwärts/Rückwärts-Binärzählers VRZ durch den Binärzähler BZ wieder gelöscht, vgl. den Zusammenhang zwischen den Fig. 3c und 3d. Am Q-Ausgang des dritten D-Flipflops D3 liegt somit ebenfalls die binäre Eins, die dem Bedingungseingang En für die niedrigere Frequenz $f_1$ des Generators GN zugeführt ist, so dass dieser für die Dauer der binären Eins mit dieser Frequenz schwingt. Dies entspricht in Fig. 3 genau den ersten k Impulsen beim ersten Zählerumlauf des Binärzählers BZ.

Der $\overline{Q}$-Ausgang des dritten D-Flipflops D3 ist mit dem Bedingungseingang Eh für die höhere Frequenz f2 verbunden, d.h., während des rückgesetzten Zustands des dritten D-Flipflops D3 erzeugt der Generator GN die höhere Frequenz $f_2$. Beim ersten Zählerumlauf des Binärzählers BZ zählt dieser die restlichen $2^n$-k Schritte mit der höheren Frequenz $f_2$. Beim zweiten Zählerumlauf erfolgt die Umschaltung schon nach k-1 Schritten der ersten Frequenz $f_1$, so dass ein Impuls der höheren Frequenz $f_2$ mehr gezählt wird.

Die höchste Frequenz $f_{max}$, die im Ausführungsbeispiel der Fig. 2 noch ausgeregelt werden kann, beträgt $2^{-(n-1)}/(1/f_1+1/f_2)$, die niedrigste Frequenz $f_{min}$ dagegen $f_1 \cdot 2^{-n}$. Drückt man die höhere Frequenz $f_2$ als Summe aus der niedrigen Frequenz $f_1$ und der Frequenzdifferenz df aus, so beträgt der «Fangbereich» $\triangle f$ des Ausführungsbeispiels nach Fig. 2:

$$f_{max}-f_{min} = \triangle f = \frac{df}{2^n(2+df/f)}; f_2 = f_1+df_1 = f+df$$

Wie bereits erwähnt, ist dabei die digitale Schrittbreite der Änderung gleich df.

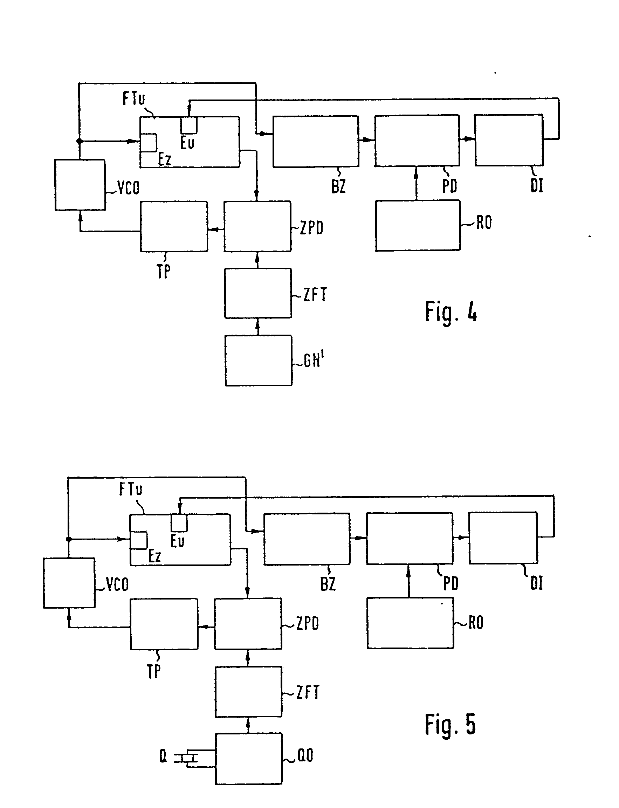

Die Fig. 4 zeigt das Blockschaltbild einer vorteilhaften Weiterbildung der Anordnung nach den Fig. 1 und 2. In der Praxis können nämlich Fälle auftreten, in denen das Umschalten zwischen den beiden Frequenzen $f_1$, $f_2$ des Generators GN besonderen zeitlichen Bedingungen unterworfen ist. Derartige Bedingungen treten beispielsweise auf, wenn die Frequenz/Phasenregelschleife nach der Erfindung bei der Horizontalsynchronisierung in Fernsehgeräten verwendet werden soll.

Die Weiterbildung nach Fig. 4 besteht im wesentlichen nun darin, dass zur Realisierung des Generators GN nach den Fig. 1 und 2 auf das Prinzip der üblichen phasenverriegelten Schleifen mit spannungsgesteuertem Oszillator zurückgegriffen wird, wobei die noch zu beschreibende nähere Modifizierung vorgenommen wird. Der Hochfrequenz-Generator GN' der Zusatzphasenregelschleife schwingt im Ausführungsbeispiel der Fig. 4 auf einer einzigen Frequenz. Die Umschaltung zwischen den beiden Frequenzen $f_1$, $f_2$ ist mittels des umschaltbaren Frequenzteilers FTu realisiert, dessen Umschalteingang Eu das Ausgangssignal der digitalen Integrierstufe DI zugeführt ist. Somit entfällt in vorteilhafter Weise die Umschaltung von frequenzbestimmenden Bauelementen, wie sie beim Generator GN nach den Fig. 1 und 2 vorgesehen ist.

Der umschaltbare Frequenzteiler FTu ist zwischen zwei ganzzahligen und benachbarten Teilungszahlen m, m-1 umschaltbar, wobei die grössere Teilungszahl m vorteilhafterweise eine Zweierpotenz ist. Wenn also z.B. m = 16 gewählt wird, so ist die kleinere Teilungszahl 15. Entsprechende Zahlungspaare wären auch 8 und 7 oder 32 und 31. Das Ausgangssignal des Hochfrequenz-Generators GN' ist dem durch die Teilungszahl m teilenden Zusatzfrequenzteiler ZFT zugeführt, dessen Ausgangssignal zusammen mit dem des umschaltbaren Frequenzteilers FTu an den beiden Eingängen der Zusatzphasenvergleichsstufe ZPD liegt. Deren Ausgangssignal steuert über das Tiefpassfilter TP den spannungsgesteuerten Oszillator VCO, dessen Ausgangssignal dem Zähleingang Ez des umschaltbaren Frequenzteilers FTu und dem Binärzähler BZ zugeführt ist und das somit in Abhängigkeit vom Ausgangssignal der digitalen Integrierstufe DI die beiden Frequenzen $f_1$, $f_2$ enthält.

Im Ausführungsbeispiel nach Fig. 5 ist der auf einer einzigen Frequenz schwingende Hochfrequenz-Generator GN' nach Fig. 4 als Quarzoszillator QO mit dem Quarz Q gezeigt.

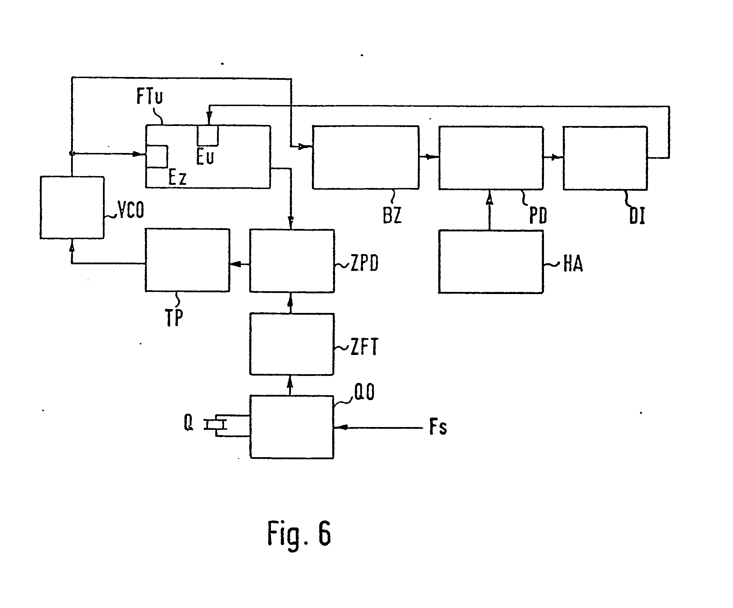

Fig. 6 zeigt schliesslich, dass der Quarzoszillator QO über ein Synchronisiersignal Fs synchronisiert werden kann, wie dies beispielsweise beim Farbhilfsträgeroszillator von Farbfernsehgeräten durch das Burstsignal erfolgt. Das Ausführungsbeispiel nach Fig. 6 ist daher auf die besondere Verwendung in Farbfernsehgeräten zugeschnitten, in welchem Fall der Referenzoszillator RO nach den Fig. 1, 2, 4 und 5 durch die Horizontalsynchronimpuls-Abtrennstufe HA gebildet wird. In diesem Fall ist die höhere Frequenz $f_2$ gleich der vierfachen Farbhilfsträgerfrequenz, also etwa 17,7 MHz, und die niedrigere Frequenz $f_1$ beträgt, wenn m = 16 gewählt ist, 16,6 MHz.

Wird dagegen der Quarzoszillator QO nicht synchronisiert, wie z.B. in Schwarzweiss-Fernsehgeräten, wird der umschaltbare Frequenzteiler FTu zwischen den Teilungszahlen m und m-1 so umgeschaltet, dass die Summe aller Periodendauern während einer Zeilendauer gleich der Gesamtperiodendauer des empfangenen Fernsehsignals ist. Beim Umschalten zwischen dem burst-synchronisierten und nichtsynchronisierten Betrieb tritt somit kein Frequenzsprung auf, da die Ausgangssignale mit den beiden Frequenzen $f_1$, $f_2$ immer mit dem Ausgangssignal des Generators GN verkoppelt sind.

## Patentansprüche

1. Frequenz/Phasenregelschleife mit einem die Frequenzkonstanz bestimmenden Referenzoszillator (RO), mit einem frequenzsteuerbaren Generator (GN) von demgegenüber geringerer Frequenzkonstanz, jedoch um eine bis drei Grössenordnungen höherer Frequenz, mit einem dem Generator (GN) nachgeschalteten Frequenzteiler (FT), von dem ein mit der Referenzfrequenz gleichfrequentes Ausgangssignal zusammen mit dem Referenzsignal einer digitalen Phasenvergleichsstufe (PD) zugeführt ist, deren Ausgangssignal die Generatorfrequenz über eine als Tiefpassfilter arbeitende digitale Integrierstufe (DI) steuert, gekennzeichnet durch folgende Merkmale:

– der Generator (GN) ist über einen Umschalteingang (Eu) zwischen zwei Frequenzen ($f_1$, $f_2$) umschaltbar, deren zweite ($f_2$) um etwa ein bis zehn Prozent grösser als die erste ($f_1$) ist,

– der Frequenzteiler (FT) ist ein mindestens n-stufiger Binärzähler (BZ),

– die Ausgänge (Az) der Binärzählerstufen sind parallel jeweils mit den n ersten Eingängen eines ersten, eines zweiten und eines dritten Koinzidenzgatters (KG1, KG2, KG3) verbunden,

– die n zweiten Eingänge des ersten Koinzidenzgatters (KG1) liegen an den Ausgängen eines ersten Festwertspeichers (ROM1) mit dem Inhalt $2^n$,

– die n zweiten Eingänge des zweiten Koinzidenzgatters (KG2) liegen an den Ausgängen eines zweiten Festwertspeichers (ROM2) mit dem Inhalt $2^{n-1}$,

– der Ausgang des zweiten Koinzidenzgatters (KG2) liegt am Zähleingang (Ez) eines (n–1) stufigen Vorwärts/Rückwärts-Binärzählers (VRZ) und über eine Verzögerungsstufe (VS) am jeweiligen Rücksetzeingang (C) eines ersten und eines zweiten D-Flipflops (D1, D2),

– der Ausgang des ersten Koinzidenzgatters (KG1) liegt am jeweiligen Takteingang des ersten bzw. eines dritten D-Flipflops (D1, D3) sowie am Rücksetzeingang (EC) des Binärzählers (BZ),

– der $\bar{\text{Q}}$-Ausgang des ersten D-Flipflops (D1) liegt am D-Eingang des zweiten D-Flipflops (D2), an dessen Takteingang der Ausgang des Referenzoszillators (RO) liegt,

– der $\bar{\text{Q}}$-Ausgang bzw. der Q-Ausgang des zweiten D-Flipflops (D2) liegt am jeweiligen Bedingungseingang (Ev, Er) für Vorwärts- bzw. Rückwärtszählen des Vorwärts/Rückwärts-Binärzählers (VRZ),

– der jeweilige D-Eingang des ersten und des dritten D-Flipflops (D1, D3) liegt auf konstantem positivem Potential (+),

– die Ausgänge (Az) der Stufen des Vorwärts/Rückwärts-Binärzählers (VRZ) liegen parallel an den n-1 niederwertigen Eingängen (El) der n zweiten Eingänge des dritten Koinzidenzgatters (KG3), dessen höchstwertiger Eingang (Em) dauernd auf die binäre Eins gesetzt ist und dessen Ausgang am Rücksetzeingang (C) des dritten D-Flipflops (D3) liegt, und

– der Q-Ausgang bzw. der $\bar{\text{Q}}$-Ausgang des dritten D-Flipflops (D3) liegt am jeweiligen Bedingungseingang (Eh, En) für die höhere bzw. niedrigere der beiden Frequenzen des Generators (GN).

2. Frequenz/Phasenregelschleife nach Anspruch 1, gekennzeichnet durch folgende Merkmale:

– der umschaltbare Generator (GN) ist als Zusatzphasenregelschleife mit analog spannungsgesteuertem Oszillator (VCO) realisiert,

– deren Hochfrequenzgenerator (GN') auf einer einzigen Frequenz schwingt und

– die einen zwischen zwei den beiden Frequenzen des Generators (GN) zugeordneten, ganzzahligen und benachbarten Teilungszahlen umschaltbaren Frequenzteiler (FTu)

– sowie einen durch die grössere (m) der beiden Teilungszahlen teilenden Zusatzfrequenzteiler (ZFT) und

– eine Zusatzphasenvergleichsstufe (ZPD) enthält,

– der das jeweilige Ausgangssignal des Zusatzfrequenzteilers (ZFT) bzw. des umschaltbaren Frequenzteilers (FTu) zugeführt ist.

3. Frequenz/Phasenregelschleife nach Anspruch 2, dadurch gekennzeichnet, dass die grössere Teilungszahl (m) eine Zweierpotenz ist.

4. Frequenz/Phasenregelschleife nach Anspruch 2 oder 3, dadurch gekennzeichnet, dass der Hochfrequenz-Generator (GN') ein Quarzoszillator (QO) ist.

5. Frequenz/Phasenregelschleife nach Anspruch 4, dadurch gekennzeichnet, dass bei der Quarzoszillator (QO) von einem weiteren Signal (Fs) synchronisiert ist.

6. Verwendung der Frequenz/Phasenregelschleife nach einem der Ansprüche 1 bis 3 als Fernsehgerät-Teilschaltung zur Erzeugung des synchronisierten Horizontalablenksignals, wobei der Referenzoszillator (RO) die Horizontalsynchronimpuls-Abtrennstufe (HA) und das Ausgangssignal der digitalen Integrierstufe (DI) das Horizontalablenksignal ist.

7. Verwendung der Frequenz/Phasenregelschleife nach Anspruch 5 als Farbfernsehgerät-Teilschaltung zur Erzeugung des synchronisierten Horizontalablenksignals, wobei der Referenzoszillator (RO) die Horizontalsynchronimpuls-Abtrennstufe (HA) und das Ausgangssignal der digitalen Integrierstufe (DI) das Horizontalablenksignal ist und wobei der Quarzoszillator (QO) der Farbhilfsträgeroszillator ist.

8. Verwendung nach Anspruch 7, dadurch gekennzeichnet, dass die höhere Frequenz ($f_2$) gleich der vierfachen Farbhilfsträgerfrequenz, insbesondere gleich 17,7 MHz, und die niedrigere Frequenz ($f_1$) insbesondere gleich 16,6 MHz ist.

**Revendications**

1. Boucle de régulation de fréquence et/ou de phase comportant: un oscillateur de référence (RO) déterminant la stabilité de fréquence; un générateur (GN) dont la fréquence peut être commandée, ce générateur ayant une stabilité de fréquence relativement moindre mais une fréquence qui est de un à trois ordres de grandeur plus élevée; un diviseur de fréquence (FT) disposé après le générateur (GN); un signal de sortie de ce diviseur à fréquence égale à la fréquence de référence, étant amené conjointement au signal de référence, à un étage comparateur de phase numérique (PD) dont le signal de sortie commande la fréquence du générateur par l'intermédiaire d'un étage intégrateur numérique (DI) opérant en filtre passe bas; caractérisé par les particularités suivantes:

– par une entrée de commutation (Eu), le générateur (GN) est commutable entre deux fréquences ($f_1$, $f_2$), la deuxième ($f_2$) étant d'environ à dix pour cent plus grande que la première ($f_1$),

– le diviseur de fréquence (FT) est un compteur binaire (BZ) ayant au moins n étages;

– les sorties (Az) des étages du compteur binaire sont reliées en parallèle aux n premières entrées d'une première, d'une deuxième et d'une troisième portes à coïncidence (KG1, KG2, KG3),

– les n deuxièmes entrées de la première porte à coïncidence (KG1) sont connectées aux sorties d'une première mémoire morte (ROM1) dont le contenu est $2^n$,

– les n deuxièmes entrées de la deuxième porte à coïncidence (KG2) sont connectées aux sorties d'une deuxième mémoire morte (ROM2) dont le contenu est $2^{n-1}$,

– la sortie de la deuxième porte à coïncidence (KG2) est appliquée à l'entrée de comptage (Ez) d'un compteur/décompteur (VRZ) à (n-1) 1étages et, par l'intermédiaire d'un étage retardateur (VS), à l'entrée de réinitialisation (C) d'une première et d'une deuxième bascules D (D1, D2),

– la sortie de la première à coïncidence (KG1) est appliquée respectivement à l'entrée d'horloge de la première et d'une troisième bascules D (D1, D3) ainsi qu'à l'entrée de réinitialisation (Ec) du compteur binaire (BZ);

– la sortie $\overline{Q}$ de la première bascule D (D1) est appliquée à l'entrée D de la deuxième bascule D (D2) à l'entrée d'horloge de laquelle est appliquée la sortie de l'oscillateur de référence (RO),

– la sortie $\overline{Q}$ et la sortie Q de la deuxième bascule D (D2) sont appliquées respectivement chacune à une entrée de condition (Ev, Er), respectivement pour comptage ascendant et pour comptage descendant, du compteur/décompteur binaire (VRZ),

– les entrées D de la première et de la troisième bascule D (D1, D3) sont à un potentiel positif constant (+),

– les sorties (Az) des étages du compteur/décompteur binaire (VRZ) sont appliquées en parallèle aux n-1 entrée (EI) de poids faibles des n deuxièmes entrées de la troisième porte à coïncidence (KG3) dont l'entrée à plus fort poids (Em) est en permanence mise sur le «un binaire» et dont la sortie est appliquée à l'entrée de réinitialisation (C) de la troisième bascule D (D3), et

– la sortie Q et la sortie $\overline{Q}$ de la troisième bascule D (D3) sont appliquées chacune à une entrée de condition (Eh, En), respectivement pour la plus haute et pour la plus basse des deux fréquences du générateur (GN).

2. Boucle de régulation de fréquence et/ou de phase selon la revendication 1, caractérisée en ce que:

– le générateur commutable (GN) est réalisé en tant que boucle de régulation de phase supplémentaire, avec oscillateur (VCO) commandé analogiquement par tension,

– le générateur (GN') de cette boucle de régulation supplémentaire oscille sur une fréquence unique, et cette boucle contient:

– un diviseur de fréquence (FTu) commutable entre deux nombres diviseurs, entiers et voisins, affectés aux deux fréquences du générateur (GN),

– un diviseur supplémentaire de fréquence (ZFT) divisant par le plus grand (m) des deux nombres diviseurs, et

– un étage comparateur de phase supplémentaire (ZPD) auquel est amené le signal de sortie du diviseur de fréquence supplémentaire (ZFT) et celui du diviseur de fréquence commutable (FTu).

3. Boucle de régulation de fréquence et/ou de phase selon la revendication 2, caractérisé en ce que le plus grand nombre diviseur (m) est une puissance de deux.

4. Boucle de régulation de fréquence et/ou de phase selon la revendication 2 ou 3, caractérisée en ce que le générateur haute fréquence (GN') est un oscillateur à quartz (QO).

5. Boucle de régulation de fréquence et/ou de phase selon la revendication 4, caractérisée en ce que l'oscillateur à quartz (QO) est synchronisé par un autre signal (Fs).

6. Application de la boucle de régulation de fréquence et/ou de phase selon l'une des revendications 1 à 3 comme élément de circuit dans un téléviseur, pour produire le signal de déviation horizontale synchronisé, l'oscillateur de référence (RO) étant l'étage (HA) séparateur d'impulsions de synchronisation horizontale et le signal de sortie de l'étage intégrateur numérique (DI) étant le signal de déviation horizontale.

7. Application de la boucle de régulation de fréquence et/ou de phase selon la revendication en tant qu'élément de circuit d'un téléviseur d'images en couleurs, pour produire le signal de déviation horizontale synchronisé, l'oscillateur de référence (RO) étant l'étage (HA) de séparation des impulsions de synchronisation horizontale et le signal de sortie de l'étage intégrateur numérique (DI) étant le signal de déviation horizontale, l'oscillateur à quartz (QO) étant l'oscillateur de sousporteuse de chrominance.

8. Application selon la revendication 7, caractérisé en ce que la plus haute fréquence ($f_2$) est égale au quadruple de la fréquence de la sousporteuse de chrominance, notamment égale à 17,7 MHz, et la fréquence la plus basse ($f_1$) est notamment égale à 16,6 MHz.

**Claims**

1. Frequence/phase-locked loop comprising a reference oscillator (RO) which is determinative of the frequency stability, a frequency-controlled generator (GN) of a comparatively lower frequency stability, but of a frequency higher by one to three orders of magnitude, a frequency divider (FT) disposed subsequently to said generator (GN) from which an output signal of the same frequency as the reference frequency is applied together with the reference signal, to a digital phase comparator (PD) whose output signal controls the generator frequency via a digital integrating stage (DI) operating as a low-pass filter, characterized by the following features:

– said generator (GN), via a switching input (Eu), is capable of being switched between two frequencies ($f_1$, $f_2$) of which the second one ($f_2$) is by about one to ten percent higher than the first one ($f_1$),

– said frequency divider (FT) is a binary counter (EZ) comprising at least n stages,

– the outputs (Az) of the stages of said binary counter (BZ) are each connected in parallel with the respective n first inputs of a first, a second and a third coincidence gate (KG1, KG2, KG3),

– the n secondary inputs of said first coincidence gate (KG1) are applied to the outputs of a first read-only memory (ROM1) with the content $2^n$,

-- the n secondary inputs of said second coincidence gate (KG2) are applied to the outputs of a second read-only memory (ROM2) with the content $2^{n-1}$,

– the output of said second coincidence gate (KG2) is applied to the counting input (Ez) of an (n-1)-stage forward-backward binary counter (VRZ) and, via a delay stage (VS), to the respective reset input (C) of a first and of a second D-flipflop (D1, D2),

– the output of said first coincidence gate (KG1) is applied to the respective clock-pulse input of the first or of a third D-flip-flop (D1, D3) as well as to the reset input (Ec) of said binary counter (BZ),

– the $\overline{Q}$-output of said first D-flip-flop (D1) is applied to the D-input of said second D-flip-flop (D2) to the clock-pulse input of which the output of said reference oscillator (RO) is applied,

– either the Q-output or the $\overline{Q}$-output of said second D-flip-flop (D2) is applied to the respective enabling input (Ev, Er) for effecting the forward or backward counting of said forward/backward binary counter (VRZ),

– the respective D-input of said first and said third D-flip-flop (D1, D3) is applied to constant positive potential ( + ),

– the outputs (Az) of the stages of said forward/backward binary counter (VRZ) are applied in parallel to the n-1 least significant inputs (EI) of the n secondary inputs of said third coincidence gate (KG3) whose most significant input (Em) is permanently set to the binary One (1) and whose output is applied to the reset input (C) of said third D-flip-flop (D3), and

– the Q-output or the $\overline{Q}$-output of said third D-flip-flop (D3) is applied to that particular enabling input (Eh, En) which serves the higher or the lower one of said two frequencies of said generator (GN), respectively.

2. A frequency/phase-locked loop as claimed in claim 1, characterized by the following features:

– said switchable generator (GN) is designed as an additional phase-locked loop comprising an analog voltage-controlled oscillator (VCO).

– with the rf generator (GN') thereof oscillating at a single frequency, and

– containing a frequency divider (FTu) which is capable of being switched between two integral and adjacent division numbers associated with said two frequencies of said generator (GN),

– as well as an additional frequency divider (ZFT) dividing by the greater one (m) of said two division numbers, and

– an additional phase comparator (ZPD)

– to which the respective input signal of said additional frequency divider (ZFT) or of said switchable frequency divider (FTu) is applied.

3. A frequency/phase-locked loop as claimed in claim 2, characterized in that said greater division number (m) is a power of two.

4. A frequency/phase-locked loop as claimed in claim 2 or 3, characterized in that said rf generator (GN') is a crystal oscillator (QO).

5. A frequency/phase-locked loop as claimed in claim 4, characterized in that said crystal oscillator (QO) is synchronized by a further signal (fs).

6. The use of the frequency/phase-locked loop as claimed in any one of claims 1 to 3 as a sub-circuit for the employment with television receivers for generating the synchronized horizontal deflection signal, in which said reference oscillator (RO) is the horizontal sync (pulse) separator (HA), and the output signal of said digital integration stage (DI) is the horizontal deflection signal

7. The use of the frequency/phase-locked loop as claimed in claim 5 as a sub-circuit for the employment with color television receivers for generating the synchronized horizontal deflection signal, in which said reference oscillator (RO) is the horizontal sync (pulse) separator (HA), and the output signal of said digital integrating stage (DI) is the horizontal deflection signal, and in which said crystal oscillator (QO) is the color subcarrier oscillator.

8. The use as claimed in claim 7, characterized in that said higher frequency ($f_2$) is equal to four times the color subcarrier frequency, in particular equal to 17.7 MHz, and that said lower frequency ($f_1$) is in particular equal to 16.6 MHz.

0 044 493

¼

Fig. 1

Fig. 2

9

0 044 493

2/4

Fig. 3

11

Fig. 4

Fig. 5

0 044 493

4/4

Fig. 6

15